# EUROPÄISCHE PATENTSCHRIFT

(11) **EP 4 440 827 B1**
(45) Veröffentlichungstag und Bekanntmachung des Hinweises auf die Patenterteilung: **04.06.2025**
(21) Anmeldenummer: 22821933.3
(22) Anmeldetag: 22.11.2022
(51) Int. Cl.: B30B 15/06, B29C 43/32, B32B 37/04

(54) **DRUCKAUSGLEICHSKÖRPER, INSBESONDERE PRESSPOLSTER ZUR AUSRÜSTUNG VON HYDRAULISCHEN EIN- UND MEHRETAGENHEIZ- UND KÜHLPRESSEN**
PRESSURE-EQUALIZING BODY, IN PARTICULAR PRESSURE PAD, FOR EQUIPPING HYDRAULIC SINGLE-DAYLIGHT AND MULTI-DAYLIGHT HEATING AND COOLING PRESSES
CORPS D'ÉGALISATION DE PRESSION, EN PARTICULIER COUSSIN DE PRESSION, POUR ÉQUIPER DES PRESSES HYDRAULIQUES DE CHAUFFAGE ET DE REFROIDISSEMENT À PLATEAU UNIQUE ET À PLATEAUX MULTIPLES

(30) Priorität: 02.12.2021 DE 202021003665 U
(43) Veröffentlichungstag der Anmeldung: 09.10.2024
(73) Patentinhaber: HUECK Rheinische GmbH, 41747 Viersen (DE)
(72) Erfinder: ESPE, Rolf, 44795 Bochum (DE)
(74) Vertreter: Bauer, Dirk
(86) Internationale Anmeldenummer: PCT/EP2022/082844
(87) Internationale Veröffentlichungsnummer: WO 2023/099288

(56) Entgegenhaltungen:
- JP-U- 3 197 305
- US-A1- 2005 014 437
- US-A1- 2006 014 463

## Beschreibung

Die Erfindung betrifft ein Presspolster zur Verwendung in einer hydraulischen Ein- oder Mehretagenheiz- und -Kühlpresse zur Herstellung von Leiterplatten, Hochdrucklaminaten oder ähnlichen Plattenkörpern, das Presspolster umfassend
- zwei auf gegenüberliegenden Seiten des Presspolsters angeordneten Außenschichten, die jeweils aus einer Folie aus einem hochtemperaturbeständigen, vorzugsweise thermoplastischen, Polymer mit einem sehr niedrigen Reibungskoeffizienten bestehen,
- eine zwischen den Außenschichten angeordnete Mittelschicht aus einem textilen Flächengebilde aus Fasern und
- zwei jeweils zwischen der Mittelschicht und der jeweiligen Außenschicht angeordnete Verbindungsschichten aus einem Fluorelastomer, vorzugsweise einem Fluorkautschuk.

Darüber hinaus betrifft die Erfindung ein Verfahren zur Herstellung eines Presspolsters zur Verwendung in einer hydraulischen Ein- oder Mehretagenheiz- und -Kühlpresse zur Herstellung von Leiterplatten, Hochdrucklaminaten oder ähnlichen Plattenkörpern, das Presspolster umfassend
- zwei auf gegenüberliegenden Seiten des Presspolsters angeordneten Außenschichten, die jeweils aus einer Folie aus einem hochtemperaturbeständigen, vorzugsweise thermoplastischen Polymer mit einem sehr niedrigen Reibungskoeffizienten, bestehen,
- eine zwischen den Außenschichten angeordneten Mittelschicht aus einem textilen Flächengebilde aus Fasern und
- zwei jeweils zwischen der Mittelschicht und der jeweiligen Außenschicht angeordnete Verbindungsschichten aus einem Fluorelastomer, vorzugsweise einem Fluorkautschuk,
wobei
zumindest ein überwiegender Anteil der Fasern, vorzugsweise sämtliche Fasern, des textilen Flächengebildes der Mittelschicht aus einem Material mit einem negativen thermischen Längenausdehnungskoeffizient bestehen.

Unter Fluorelastomeren (oder hier synonym "fluorierte Elastomere") sollen im Sinne der vorliegenden Erfindung neben Fluorkautschuken auch weitere Gruppen fluorierter Elastomere, wie z. B. Perfluorkautschuk (FFKM), Tetrafluorethylen/Propylen-Kautschuke (FEPM) oder fluorierter Silikonkautschuk (FVMQ) verstanden werden, wobei letzerer sich bei Versuchen mit erfindungsgemäßen Presspolstern als tendenziell weniger geeignet herausgestellt hat.

### Stand der Technik

Presspolster der eingangs beschriebenen Art werden in verschiedenen hydraulischen Ein- und Mehretagen-Heiz- und Kühlpressen eingesetzt und haben die Aufgabe, den Pressdruck gleichmäßig und vollflächig auf die herzustellenden Produkte, bei denen es sich um Leiterplatten zur Herstellung elektronischer Schaltungen, Hochdrucklaminate (HPL = High Pressure Laminate), bestehend aus mehreren Lagen aus mit Melamin- und Phenol-Harz getränkten Papieren oder ähnliche Plattenkörper handelt, möglichst gleichmäßig zu verteilen und vollflächig auf die herzustellenden Produkte zu übertragen. Bei den an solche Presspolster, die auch als Druckausgleichskörper bezeichnet werden, zu stellenden Anforderungen handelt es sich einerseits um eine möglichst hohe und über die Fläche gleichmäßige Wärmeleitfähigkeit, um auf diese Weise die Prozesszeiten bei den Aufheiz- und Abkühlvorgängen kurz zu halten, um eine hohe Elastizität bzw. ein hohes Rückstellvermögen um sich nach Aufhebung des Pressdrucks am Ende eines Presszyklus wieder möglichst in den Ausgangszustand zurückzustellen, und zwar über eine möglichst große Anzahl von Presszyklen. Letztgenannte Anforderung ist auch einem geringen so genannten "Druckverformungsrest" gleichzusetzen. Darüber hinaus wird an derartige Presspolster derartige Aufgaben gestellt, eine möglichst geringe Haft- und Gleitreibung aufzuweisen, also insbesondere einen niedrigen Haft- und Gleitreibungskoeffizienten, insbesondere gegenüber den metallischen Heizplatten in der Presse. Insbesondere bei der Leiterplattenherstellung sind die Anforderungen an die verwendeten Presspolster besonders hoch, da derartige Produkte unter sehr hohen Pressdrücken, langen Presszeiten und hohen Presstemperaturen hergestellt werden. Zum einen sollen die Leiterplatten eine sehr geringe Dickentoleranz aufweisen und zum anderen dürfen beim Herstellprozess keine partikelförmigen Verunreinigungen an den Leiterplatten entstehen bzw. anhaften, da hierdurch bei der Weiterverarbeitung der Leiterplatten die Gefahr von Fehlern in der später daraus hergestellten, gedruckten elektronischen Schaltung signifikant erhöht würde. In diesem Zusammenhang ist ein geringer Haft- und Gleitreibungskoeffizient von Bedeutung, um bei der durch den Temperaturwechsel im Presspolter bedingten Ausdehnungs- und Kontraktionsprozess im Falle von Anhaftungen zwischen Presspolster und Pressplatte bzw. Pressblech verstärkt Abrieberscheinungen an der Oberfläche der Presspolter auftreten würden.

Bei der Herstellung von Leiterplatten werden als Substratmaterialien typischerweise Epoxid, Polyamid, Polyethylenterephthalate und Polyethylennaphthalate aufgrund ihrer insofern besonders positiven physikalischen und chemischen Eigenschaften verwendet. Nach wie vor ist das am häufigsten verwendete Substrat in der Leiterplattenherstellung ein glasfaserverstärktes (Fiberglas-)Epoxidharz mit einer ein- oder beidseitig verklebten Kupferfolie. Durch die feste Struktur und Haltbarkeit bietet ein solcher mit Fiberglas verstärkter Epoxidharz-Verbundaufbau eine außergewöhnliche mechanische Festigkeit. Durch die Imprägnierung mit Epoxidharz ergibt sich im Übrigen ein hervorragender elektrischer Isolator und ein schwer entflammbares Material. Letztere Eigenschaft ist von zunehmender Bedeutung, da die Temperaturen bei der Verwendung bestimmter elektronischer Komponenten in gedruckten elektronischen Schaltungen tendenziell ansteigen.

Leiterplatten sind typischerweise das Kernstück elektronischer Komponenten und Schaltungen, mit denen eine Energie-, Signal- und Datenübertragung von einer Quelle zu einem gewünschten Zielort erfolgt. Die zwei Hauptfunktionen einer Leiterplatte sind zum einen die stabile Befestigung elektronischer Bauteile und zum anderen die leitende Verbindung zwischen den unterschiedlichen Komponenten auf der Leiterplatte. Dabei wird der Stromfluss zwischen den einzelnen elektronischen Bauteilen auf derselben Leiterplatte durch Leiterbahnen, Tracks oder Signalbahnen ermöglicht. Diese werden aus den Kupferblechen geätzt, die die Randschichten auf der aus dem nichtleitenden Substrat (Fiberglas-Epoxidharz) bestehenden Mittelschicht bilden. Die Leiterplatte muss während ihrer Lebensdauer eine hohe Leistungsfähigkeit beibehalten, um Übertragungsverzögerungen oder eine ungenaue Datenübertragung zu vermeiden.

Bei einer bekannten einfachen Ausführung einer solchen Leiterplatte handelt es sich um eine so genannte einseitige Stand-Leiterplatte, die nur auf einer Seite Leiterbahnen, die aus einer Kupferfolien-Kaschierung erzeugt werden, aufweist. Bei steigender Komplexität sind die Leiterplatten beidseitig kupferkaschiert. Falls dies nicht ausreichend ist, besteht die Möglichkeit zu einer so genannten mehrlagigen Multilayer-Leiterplatte. In diesem Fall werden mehrere dünne Epoxidharzplatten, die alle mit kaschierten Leiterplatten ausgestattet sind, passgenau mit Prepregs verbunden. Bei sehr komplexen Schaltungen kann eine derartige Multilayer-Leiterplatte aus bis zu 50 Lagen mit abwechselnder Schichtung von Epoxidharzplatte und Kupferfolie bestehen.

Im Rahmen des Herstellungsprozesses werden derartige Leiterplatten bzw. deren "Rohlinge" in Presspaketen zusammengelegt und zwischen Pressblechen, die zum größten Teil aus Edelstahl mit einer glatten Oberfläche bestehen, in die Heiz- und Kühlpresse eingefahren. Zum Ausgleich von Dickentoleranzen in der Pressenanlage werden zwischen den Pressblechen und den Heizplatten der Presse die eingangs beschriebenen Presspolster eingesetzt. Die einzelnen Etagen der Presse sind mit Heizplatten, die sowohl zum Aufheizen als auch zum Kühlen, und zwar typischerweise jeweils mittels Durchströmung durch ein Thermoöl benutzt werden können, ausgerüstet. Unter hohem Druck und Temperatur schmilzt zunächst das in dem Pressling eingesetzte Harz, verbindet dabei die Leiterbahnen mit der beispielsweise Epoxidharz-Zwischenschicht und härtet anschließend zu einer fertigen Leiterplatte aus. Je nach benötigter Kondensations- und Polymerisationszeit wird der zunächst durchgeführte Heizprozess unter Druckbeibehaltung anschließend durch eine Kühlung unterbrochen.

Der Stand der Technik bei Presspoltern für Pressenanlagen zur Herstellung der vorstehend beschriebenen Hochdrucklaminate wird auch heute sehr zahlreich noch von Presspolstern aus Papiermaterialien wie Wollfilzpapier oder Natron-Kraftpapier gebildet. Darüber hinaus kommen vermehrt auch Kunststoffpolster zum Einsatz, wobei es in Form von textilen Flächengebilden aus synthetischen Fasern oder aus plattenförmigen bzw. schichtförmigem Kunststoffmaterial ohne ein integriertes textiles Flächengebilde in Form eines Gewebes, Gewirks, Gestricks oder Vlieses.

Presspolster der vorgenannten Art offenbaren US 2005/014437 A1, US 2006/014463 A1 und JP 3 197305 U. Aus der US 4,461,800 A ist ein Presspolster für eine Formpresse bekannt, das einen laminierten Kern aufweist, der mindestens eine harte Kissenschicht umfasst, die zwischen zwei starren Platten angeordnet ist, die eine hohe Wärmeleitfähigkeit aufweisen. Darüber hinaus weist das bekannte Presspolster zwei weiche Kissenschichten auf, die poröse elastische Schichten beinhalten. Dabei sind die weichen Kissenschichten mit jeder der Oberflächen des laminierten Kerns verklebt. Außerdem umfasst die vorgenannte harte Kissenschicht mindestens eine poröse elastische Folie, die mit einem Bindemittel imprägniert ist. Das vorbeschriebene Presspolster ist kompliziert in seinem Aufbau und die Lebensdauer vergleichsweise gering.

Bei dem in der EP 1 084 821 A beschriebenen Presspolster ist eine Lage aus einem filzartigen Polstermaterial mit gegenüberliegenden ersten und zweiten Oberflächen vorhanden, sowie ein Kernteil, das auf der ersten Oberfläche des Polstermaterials ausgebildet ist, wobei das Kernteil eine erste Oberfläche in Kontakt mit der ersten Oberfläche des Polstermaterials und eine gegenüberliegende zweite Oberfläche aufweist. Darüber hinaus umfasst die Lage aus filzartigem Polstermaterial ein Grundgewebe, das aus Garnmaterial gewoben ist, und eine Vliesfaserschicht, die durch Vernadelung integriert ist. Ferner besteht das Kernteil aus einem elastischen Material, aus einem schwammartigen Gummimaterial oder einem thermoplastischen Elastomer, welches verteilte Hohlräume in Form geschlossener, unabhängiger Zellen einschließt.

Darüber hinaus offenbart die EP 1 978 528 A ein Presspolter zur Herstellung von Leiterplatten, das ein Gewebe, ein Papier, einen Film oder eine blattartige Struktur aufweisen kann, die jeweils als Schicht mit mindestens einer weiteren Schicht aus einem Fluorelastomer kombiniert ist. Vorzugsweise soll das Fluorelastomer eine Fluorkautschukkomponente des Polyol-Vulkanisions-Systems, ein Vulkanisationsmittel, einen Vulkanisationsbeschleuniger sowie einen Säure-Akzeptor aufweisen.

Ferner ist aus der EP 0 842 764 A ein Presspolster aus einem textilen Garn bekannt, das unter hoher mechanischer Beanspruchung eine verlängerte Einsatzdauer zeigen soll, wobei das textile Garn aus einer schwer entflammbaren Melaminharzfaser besteht.

Des Weiteren geht aus der EP 0 493 630 B1 ein Presspolster hervor, das aus asbestfreiem Material besteht, und für einen Einsatz in Hochdruck-Einetagenpressen für die Herstellung von Hochdrucklaminaten vorgesehen ist.

Darüber hinaus ist aus der DE 103 37 403 A ein Presspolster bekannt, das ein Gewebe aufweist, das Fäden enthält, die zumindest zum Teil aus einem hochtemperturbeständigen Polymermaterial bestehen. Die Besonderheit besteht in diesem Falle darin, dass die Fäden, die das Polymermaterial aufweisen, einen Anteil eines Gases von mindestens 1 % enthalten.

Außerdem geht aus der EP 1 386 723 B1 ein Presspolster hervor, das ein Gewebe aufweist, dessen Kette und/oder Schuss jeweils alternierend Fadenarten mit quer zu der Fadenachse unterschiedlicher Elastizität aufweist.

Ein weiteres Presspolster für Hochdruckanwendungen geht aus der EP 0 488 071 A hervor. Dieses Presspolster soll für Pressdrücke zwischen 400 N/cm² und 1200 N/cm² und Temperaturen zwischen 160°C und 200°C geeignet sein.

Schließlich offenbart die DE 200 11432 U noch ein Presspolster aus asbestfreiem Material für Hochdruck-Mehretagenpressen oder für Hochdruck-Einetagen-Kurztaktpressen, und zwar jeweils zur Herstellung von Hochdrucklaminaten. Das bekannte Presspolster weist ein textiles Gewebe auf, das ein Garn aus einem aromatischen Polyamid sowie Metallfäden enthält. Insbesondere soll das Gewebe zumindest einseitig lediglich oberflächlich mit einer Beschichtung aus einem hitzebeständigen und druckfesten Polymermaterial versehen sein. Die Beschichtung überdeckt das Gewebe vollflächig in Form einer durchgängigen Schicht.

Alle vorstehend beschriebenen Presspolster können die hohen Anforderungen, wie sie bei einem Einsatz in Hochdruck-Pressenanlagen zur Herstellung von Hochdrucklaminaten zu stellen sind, nämlich eine lange Einsatzdauer, sehr gute Rückstelleigenschaften, gleichmäßigen Druckausgleich sowie einen sehr geringen Reibungskoeffizienten nur unvollständig erfüllen.

### Aufgabe

Der Erfindung liegt die Aufgabe zugrunde, ein Presspolster für den Einsatz in Ein- oder Mehretagen-Heiz- und Kühl-Pressen vorzuschlagen, das den wie vorstehend genannten Anforderungen bei der Herstellung von Hochdrucklaminaten besser gerecht wird.

### Lösung

Ausgehend von einem Presspolster der eingangs beschriebenen Art wird die vorstehende Aufgabe erfindungsgemäß dadurch gelöst, dass zumindest ein überwiegender Anteil der Fasern, vorzugsweise sämtliche Fasern, des textilen Flächengebildes der Mittelschicht aus einem Material mit einem negativen thermischen Längenausdehnungskoeffizient (linearer Wärmeausdehnungskoeffizient) besteht bzw. bestehen Dabei bezieht der Längenausdehnungskoeffizient auf eine Ausdehnung in Faserlängsrichtung.

Weil die Fasern, aus denen das textile Flächengebilde der Mittelschicht gebildet wird, gänzlich oder zumindest zu einem überwiegenden Anteil aus einem Material mit einem negativen thermischen Längenausdehnungskoeffizient bestehen, kommt es - entgegen dem Verhalten bei bekannten Presspolstern der hier in Rede stehenden Konstruktionsart - nicht zu einer Ausdehnung während des Pressvorgangs, d.h. bei der Aufheizung innerhalb der Pressenanlage, sondern im Gegenteil zu einer Verkürzung der Fasern. Auch wenn das hochtemperaturbeständige Material der Außenschichten des erfindungsgemäßen Presspolsters und/oder das Material bzw. die Materialien der Verbindungsschichten, nämlich ein Fluorelastomer, vorzugsweise ein Fluorkautschuk, einen positiven thermischen Längenausdehnungskoeffizienten besitzt bzw. besitzen, wirkt sich die Verwendung eines Materials mit negativem thermischen Längenausdehnungskoeffizienten in dem textilen Flächengebilde der Mittelschicht gleichwohl überraschenderweise sehr positiv aus, da die Gesamtausdehnung des Presspolsters gegenüber dem Stand der Technik signifikant reduziert wird. Da die Fasern des textilen Flächengebildes der Mittelschicht typischerweise einen wesentlich größeren Elastizitätsmodul als das Fluorelastomer, vorzugsweise das Fluorkautschuk-Material, der die Mittelschicht umgebenden Verbindungsschichten aufweist, zwingt die sich längenmäßig zusammenziehende Mittelschicht den beiden quasigummielastische Eigenschaften aufweisenden Verbindungsschichten die Kontraktion unter Ausbildung einer größeren Druckspannung in den Verbindungsschichten auf, auch wenn das Material der Verbindungsschichten ohne das Zusammenwirken mit der sich kontrahierenden Mittelschicht eine längenmäßige Ausdehnung bei einer Temperaturerhöhung erfahren hätte. Dasselbe gilt - auch wenn in etwas abgeschwächter Weise - für die beiden aus einem hochtemperaturbeständigen Polymer bestehenden Außenschichten, da diese aufgrund der ausgeprägten Klebewirkung der Verbindungsschichten aus dem Fluorelastomer, vorzugsweise der Fluorkautschuk-Verbindungsschichten, ebenfalls ihrem eigentlich gegebenen Ausdehnungsbestreben nicht in vollem Umfang folgen können.

Somit lässt sich aufgrund der erfindungsgemäß in der Mittelschicht in Form eines textilen Flächengebildes verarbeiteten Fasern mit einem negativen thermischen Längenausdehnungskoeffizienten die Ausdehnung des Presspolsters insgesamt, d.h. auch im Bereich seiner Außenschichten, in nicht vorherzusehender Weise reduzieren. Dies ist deshalb für die Praxis von sehr großer Bedeutung weil insbesondere große Längenausdehnungen der bekannten Presspolster - trotz des bereits im Stand der Technik bewusst sehr klein gewählten Reibungskoeffizienten des Materials der Außenschichten - zu unerwünschten Relativbewegungen zwischen der Außenschicht und dem damit in Kontakt kommenden Pressblech bzw. der Heizplatte und infolgedessen zu Abrieb von Polstermaterial, d.h. Material der Außenschicht, führen und auf diese Weise eine sehr nachteilige Verunreinigung innerhalb der Pressenanlage bzw. der damit hergestellten gedruckten Schaltungen bewirken würden. Wie bereits weiter oben ausgeführt, können Verschmutzungen auf den Leiterplatten im Rahmen von deren weiterer Verarbeitung zu gedruckten Schaltungen zu Fehlfunktionen bei Letzteren führen.

Selbst wenn bei dem erfindungsgemäßen Presspolster im Endeffekt an den Außenseiten - trotz des negativen thermischen Längenausdehnungskoeffizienten der Fasern der Mittelschicht - eine (geringfügige) Ausdehnung in Folge der Temperaturerhöhung während des Pressvorgangs eintritt, wird diese durch die Verwendung eines Materials mit einem sehr niedrigen Reibungskoeffizienten an der Außenschicht bestmöglich abgemildert, da aufgrund dieses geringen Reibungskoeffizienten ein echtes Anhaften im Sinne von Ankleben des Außenschichtmaterials an dem Pressblech oder der Heizplatte vermieden wird. Im Falle eines solchen Anklebens könnten sich bei einem anschließenden gewaltsamen Ablösen leicht Schäden an dem Presspolster in Form von herausgerissenen oder abgelösten Stücken ergeben, die wiederum den vorstehend beschriebenen Verunreinigungseffekt und damit die besagte Qualitätseinbuße bei den hergestellten Leiterplatten zur Folge hätten.

Unter einem sehr niedrigen Reibungskoeffizienten des Polymermaterials der Außenschichten ist im Sinne dieser Anmeldung ein Reibungskoeffizient von kleiner als 0,06, vorzugsweise kleiner als 0,05, weiter vorzugsweise kleiner als 0,04, zu verstehen

Bei den Fasern im Sinne der hier offenbarten Erfindung kann es sich um Filamente, nämlich Monofilamente oder Multifilamente, beispielsweise auch (verzwirnte) Multifilamente, handeln, die sodann mit den klassischen textiltechnischen Verarbeitungsmethoden (Weben, Stricken, Wirken, Vliesherstellung) zu einem textilen Flächengebilde verarbeitet werden. Es kann sich bei den Fasern nach der vorliegenden Anmeldung um Stapelfasern oder Endlosfasern, beispielsweise Spinnfasern, handeln, die zu einem Vliesmaterial verarbeitet sind, das dann das textile Flächengebilde der Mittelschicht darstellt.

Der Begriff "hochtemperaturbeständiges Polymer" der Außenschichten im Sinne der vorliegenden Anmeldung ist dahingehend zu verstehen, dass damit eine Temperaturbeständigkeit bis mindestens 240 °C, vorzugsweise bis mindestens 260 °C, noch weiter vorzugsweise bis 300°C gemeint ist.

Vorzugsweise weisen die Fasern des textilen Flächengebildes der Mittelschicht Para-Aramid und/oder Meta-Aramid und/oder Carbon und/oder Glas auf. Dabei ist es bevorzugt, dass die Fasern ausschließlich aus einem der vorgenannten Materialien oder aus einer Fasermischung aus mehreren der vorgenannten Materialien bestehen. Neben einem negativen thermischen Längenausdehnungskoeffizienten besitzen die vorgenannten Fasern auch eine zur Gewährleistung der geforderten Stabilisierungsfunktion der Mittelschicht erforderliche hohe Zugfestigkeit.

Gemäß der Erfindung ist des Weiteren vorgesehen, dass die Mittelschicht ein Gewebe und/oder ein Gewirk und/oder ein Gestrick und/oder ein Vliesmaterial und/oder ein Filzmaterial, vorzugsweise ein Nadelfilz, aufweist.

Gemäß einer besonders bevorzugten Ausführungsform des anmeldungsgemäßen Presspolsters ist das textile Flächengebilde der Mittelschicht, vorzugsweise auf beiden gegenüberliegenden Seiten, oberflächlich mit aufgenadelten Kurzfasern, bestehend vorzugsweise aus demselben Material wie das textile Flächengebilde oder aus einem anderen Material als die Fasern des textilen Flächengebildes, versehen. Die aufgenadelten Kurzfasern, die sich zum überwiegenden Teil in eine Richtung senkrecht zu der bzw. den entgegengesetzten Oberfläche(n) erstrecken, bewirken neben einer Zugspannungsstabilisierung auch noch einen zusätzlichen Polstereffekt aufgrund ihrer senkrechten Ausrichtung.

Die Erfindung weiter ausgestaltend ist vorgesehen, dass die Folien der Außenschichten aus Polytetrafluorethylen (PTFE), Ethylen-Tetrafluorethylen (ETFE), Perfluor-Alkoxy-Polymer (PFA), Tetrafluorethylen-Hexafluorpropylen-Copolymer (FEP) oder Polychlortrifluortritheylen (PCTFE) besteht. Die vorgenannten Materialien zeichnen sich allesamt durch eine hohe Temperaturbeständigkeit und einen geringen Reibungskoeffizienten aus.

Um eine starke und dauerhafte Anbindung der Außenschicht an die Verbindungsschicht zu erzielen, kann eine der Verbindungsschicht zugewandte Oberfläche der Folie der Außenschicht, vorzugsweise vollflächig, haftverstärkend präpariert, d.h. mit flüssigem Ammoniak geätzt oder einer Behandlung mit einer Natrium-Naphthalin-Lösung oder einer Plasmabehandlung unterzogen, insbesondere chemisch geätzt oder einer Ionisationsbehandlung, vorzugsweise mittels eines Niederdruckplasmas, unterworfen ist.

Bei dem (zunächst teilvernetzt vorliegenden) Fluorelastomer, vorzugsweise Fluorkautschuk-Polymerisat, kann es sich erfindungsgemäß um
- das Copolymer von Vinylidenfluorid (VDF) und Hexafluorpropylen (HFP) oder
- das Terpolymer von Vinylidenfluorid (VDF), Hexafluorpropylen (HFP) und Tetrafluorethylen (TFE) oder
- ein Polymerisat aus Vinylidenfluorid (VDF), Hexafluorpropylen (HFP), Tetrafluorethylen (TFE) und Perfluormethylninylether (PMVE) oder
- ein Polymerisat aus Vinylidenfluorid (VDF), Hexafluorpropylen (HFP), Tetrafluorethylen (TFE), Perfluormethylninylether (PMVE) und Ethen
handeln. In Bezug auf die Vernetzung der Komponenten des (zunächst teilvernetzten), Fluorelastomer, vorzugsweise Fluorkautschuk-Polymerisats, kommen grundsätzlich eine peroxidische, diaminische oder bisphenolische Vernetzung in Frage. Von diesen drei Vernetzungsmechanismen ist die diaminische Vernetzung die älteste. Hierbei werden blockierte Diamine als Vernetzer eingesetzt und insbesondere eine gute Haftung zwischen dem Elastomer und beispielsweise Metallen erzielt. Die zweite Vernetzungsart ist der bisphenolische Mechanismus, auch Dihydroxy-Mechanismus genannt. Die bisphenolische Vernetzung zeigt eine bessere Beständigkeit gegen Hydrolyse und höhere Temperaturen sowie eine Verbesserung im Hinblick auf den so genannten Druckverformungsrest.

Außerdem lassen sich die Fluorkautschuke auch peroxydisch (Triacin-Verfahren) durch freie Radikale vernetzen. Versuche mit einem Silikonelastomer (als Alternative zu einem Fluorkautschuk) haben eine wesentlich kürzere Einsatzdauer gezeigt und die Stabilität und Maßhaltigkeit war weniger gut.

Im Hinblick auf das eingangs beschriebene Verfahren zur Herstellung eines Presspolsters zur Verwendung in einer hydraulischen Ein- oder Mehretagenheiz- und -kühlpresse wird die zugrunde liegende Aufgabe dadurch gelöst, dass das Fluorkautschukmaterial in einem vorvernetzten Zustand jeweils zwischen einer der beiden Außenschichten und die Mittelschicht eingebracht und dort gleichmäßig und vollflächig verteilt wird, und dass in einem solchermaßen gebildeten Mehrschicht-Verbund unter vollflächigem Druck und erhöhter Temperatur das Fluorkautschukmaterial in einen endvernetzten Zustand überführt und dadurch der Mehrschicht-Verbund dauerhaft mit dem Presspolster verklebt wird.

Bei dieser Herstellungsweise wird ein Mehrschicht-Verbund zunächst unter Verwendung des lediglich vorvernetzten und somit nicht endvernetzten Fluorkautschukmaterials hergestellt, der bereits einen für die weitere Handhabung hinreichenden Zusammenhalt besitzt. Um einen als Hochdruck-Presspolster verwendbaren Mehrschicht-Verbund mit dauerhafter und sehr inniger Verbindung zwischen den einzelnen Schichten zu erreichen, wird der die Vorstufe bildende Mehrschicht-Verbund sodann unter erhöhtem Druck und erhöhter Temperatur endvernetzt.

Bei diesem Endvernetzungsvorgang liegt die Temperatur typischerweise zwischen 130°C und 160°C und der Druck typischerweise zwischen 0,5 N/mm² und 1,0 N/mm². Zur Herstellung des Presspolsters aus dem zunächst lediglich mittels des vorvernetzten fluorierten Kautschuks, vorzugsweise Fluorkautschuks, zusammengehaltenen Mehrschicht-Verbund können verschiedene bekannte Anlagentypen verwendet werden. So kann z.B. eine einfache Pressenanlage eingesetzt werden, bei der das Presspolster während des Pressvorgangs stillsteht. Eine Variante ist eine Endlos-Bandanlage mit Kühleinrichtung, durch die das Presspolster während des Endvernetzungsvorgangs hindurchgefahren wird. Dabei wird die Presszeit über die Bandgeschwindigkeit gesteuert. Eine weitere Möglichkeit ist die Verwendung einer Walzenkaschieranlage, die auch als "Auma-Laminieranlage" bezeichnet wird. Hierbei wird ein umlaufendes Stahlband über eine teilbeheizbare Trommel geführt und der Pressdruck wird über die Anpresskräfte des Stahlbandes an die Trommel geregelt.

### Ausführungsbeispiel

Die Erfindung wird nachfolgend anhand eines Ausführungsbeispiels eines Presspolsters, das in der Zeichnung dargestellt ist, näher erläutert.

Es zeigt:

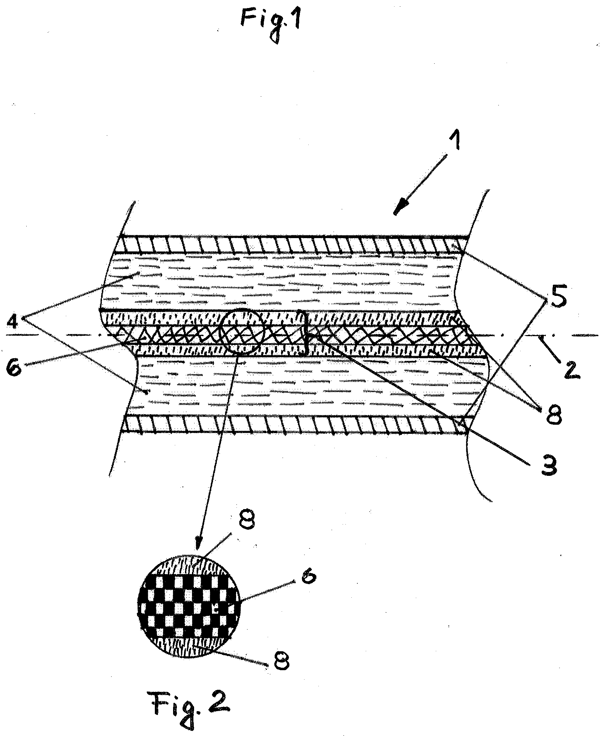

- Figur 1:: Einen ausschnittsweisen Querschnitt durch das Presspolster und
- Figur 2:: eine Ausschnittsvergrößerung der Mittellage des Presspolsters gemäß Figur 1.

Ein Presspolster 1 besitzt ein zu einer Mittelebene 2 symmetrischen Aufbau und umfasst eine Mittelschicht 3, eine auf beiden Seiten der Mittelschicht angeordnete Verbindungsschicht 4 und zwei die äußeren Oberflächen des Presspolsters 1 ausbildenden Außenschichten 5.

Die Mittelschicht umfasst ein textiles Flächengebilde 6, das aus einem ein- oder mehrlagigen Gewebe mit darauf beidseitig aufgenadelten Para-Aramid-Kurzfasern 8. Die Kurzfasern stehen mit ihrer Faserlängsrichtung senkrecht auf den Oberflächen des Gewebes. Insgesamt bildet der Verbund aus Gewebe und den aufgenadelten Kurzfasern 8 einen so genannten Nadelfilz.

Bei beiden Außenschichten 5 handelt es sich jeweils um eine Folie aus einem PTFE mit einer Dicke von ca. 200 µm. Bei PTFE handelt es sich um ein hochtemperaturbeständiges Material mit hoher Abriebbeständigkeit und einem sehr geringen Reibungskoeffizienten. Jeweils die der Mittelschicht 3 zugewandte Oberfläche der Außenschicht 5 ist chemisch mittels Anätzung behandelt, konkret mittels Ammoniak geätzt.

Die Erzeugung eines Mehrschichtverbundes mit sehr inniger Anhaftung bzw. Verbindung der einzelnen Schichten erfolgt unter Verwendung eines zunächst nur teilvernetzten bzw. vorvernetzten Fluorkautschuks, der beispielsweise aus den Monomeren Vinylidenfluorid und Hexafluorpropylen besteht. Die aus dem Fluorkautschuk gebildete Verbindungsschicht 4 besitzt eine Dicke von ca. 800 µm, wobei der teilvernetzte Fluorkautschuk mittels eines Haftvermittlers so modifiziert wurde, dass er besonders gute Verklebungseigenschaften aufweist. Einerseits steht somit der Fluorkautschuk mit der angeätzten Oberfläche der Außenschicht 5 in Kontakt und andererseits mit den aufgenadelten Kurzfasern 8 des textilen Flächengebildes 6 der Mittelschicht 3. Aufgrund der zunächst vergleichsweise geringen Konsistenz des vorvernetzten Fluorkautschuks dringt dieser tief in die Bereiche zwischen den Kurzfasern 8 des textilen Flächengebildes 6 ein, weshalb der Verbund besonders innig und dauerhaft ist.

Im vorliegenden Fall wurde der wie vorstehend beschriebenen Mehrschicht-Verbund zwecks Endvernetzung des Fluorkautschuks in einer Walzenkalanderanlage unter Druck (0,5 N/mm²) und Temperatur (150 °C) endvernetzt .

Bei Versuchen mit einem Presspolster 1 wie vorstehend beschrieben, konnten hervorragende Eigenschaften festgestellt werden. Bei einer Verwendung des Presspolsters 1 in einer Pressenanlage zur Herstellung von mehrlagigen Multilayer-Leiterplatten zeigte ich gegenüber vorbekannten Presspolstern eine enorm hohe Anzahl von möglichen Presszyklen. Die Maßhaltigkeit des Presspolsters 1 war nach Ende des Versuchs nahezu vollständig gegeben. Es konnte selbst nach einer sehr langen Einsatzdauer noch eine genügend hohe Restrückstellung nach Wegnahme des Pressdrucks festgestellt werden. Die Oberflächen der aus PTFE-Folie bestehenden Außenschichten 5 zeigten keine Veränderungen im Hinblick auf Abrieb oder Beschädigungen.

### Bezugszeichenliste

- 1: Presspolster
- 2: Mittelebene
- 3: Mittelschicht
- 4: Verbindungsschicht
- 5: Außenschicht
- 6: textiles Flächengebilde
- 8: Kurzfaser

## Patentansprüche

1. Presspolster (1) zur Verwendung in einer hydraulischen Ein- oder Mehretagenheiz- und -Kühlpresse zur Herstellung von Leiterplatten, Hochdrucklaminaten oder ähnlichen Plattenkörpern, das Presspolster (1) umfassend
- zwei auf gegenüberliegenden Seiten des Presspolsters (1) angeordneten Außenschichten (5), die jeweils aus einer Folie aus einem hochtemperaturbeständigen, vorzugsweise thermoplastischen, Polymer mit einem sehr niedrigen Reibungskoeffizienten bestehen,
- eine zwischen den Außenschichten (5) angeordnete Mittelschicht (3) aus einem textilen Flächengebilde (6) aus Fasern und
- zwei jeweils zwischen der Mittelschicht (3) und der jeweiligen Außenschicht (5) angeordnete Verbindungsschichten (4) aus einem fluorierten Kautschuk, vorzugsweise einem Fluorkautschuk,
**dadurch gekennzeichnet, dass** zumindest ein überwiegender Anteil der Fasern, vorzugsweise sämtliche Fasern, des textilen Flächengebildes (6) der Mittelschicht (3) aus einem Material mit einem negativen thermischen Längenausdehnungskoeffizient besteht bzw. bestehen.

2. Presspolster (1) nach Anspruch 1, **dadurch gekennzeichnet, dass** Fasern des textilen Flächengebildes (6) der Mittelschicht (3) aus Para-Aramid und/oder aus Meta-Aramid und/oder aus Karbon (Kohlenstoff) und/oder aus Glas bestehen, vorzugsweise, dass die Fasern ausschließlich aus einem der vorgenannten Materialien oder aus einer Fasermischung aus mehreren der vorgenannten Materialien bestehen.

3. Presspolster (1) nach Anspruch 1 oder 2, **dadurch gekennzeichnet, dass** die Mittelschicht (3) ein Gewebe und/oder ein Gewirk und/oder ein Gestrick und/oder ein Vliesmaterial und /oder ein Filzmaterial, vorzugsweise ein Nadelfilz, aufweist.

4. Presspolster (1) nach einem der Ansprüche 1 bis 3, **dadurch gekennzeichnet, dass** das textile Flächengebilde (6) der Mittelschicht (3), vorzugsweise auf beiden gegenüber liegenden Seiten, oberflächlich mit aufgenadelten Kurzfasern (8), bestehend vorzugsweise aus demselben Material wie das textile Flächengebilde (6) oder aus einem anderen Material als die Fasern des textilen Flächengebildes (6), versehen ist.

5. Presspolster (1) nach einem der Ansprüche 1 bis 4, **dadurch gekennzeichnet, dass** die Folien der Außenschichten (5) aus Polytetrafluorethylen (PTFE), Ethylen-Tetrafluorethylen (ETFE), Perfluor-Alkoxy-Polymer (PFA), Tetrafluorethylen-Hexafluorpropylen-Copolymer (FEP) oder Polychlortrifluortritheylen (PCTFE) besteht.

6. Presspolster (1) nach einem der Ansprüche 1 bis 5, **dadurch gekennzeichnet, dass** eine der Verbindungsschicht (4) zugewandte Oberfläche der Folie der Außenschicht (5), vorzugsweise vollflächig, haftverstärkend präpariert, insbesondere chemisch geätzt oder einer Ionisationsbehandlung vorzugsweise mittels eines Niederdruckplasmas unterworfen ist.

7. Presspolster (1) nach einem der Ansprüche 1 bis 6, **dadurch gekennzeichnet, dass** das (teilvernetzte) Fluorkautschuk-Polymerisat
- aus dem Copolymer von Vinylidenfluorid (VDF) und Hexafluorpropylen (HFP) oder
- aus dem Terpolymer von Vinylidenfluorid (VDF), Hexafluorpropylen (HFP) und Tetrafluorethylen (TFE) oder
- aus einem Polymerisat aus Vinylidenfluorid (VDF), Hexafluorpropylen (HFP), Tetrafluorethylen (TFE) und Perfluormethylninylether (PMVE) oder
- aus einem Polymerisat aus Vinylidenfluorid (VDF), Hexafluorpropylen (HFP), Tetrafluorethylen (TFE), Perfluormethylninylether (PMVE) und Ethen
besteht.

8. Presspolster (1) nach einem der Ansprüche 1 bis 7, **dadurch gekennzeichnet, dass** Komponenten des (teilvernetzten) Fluorkautschuk-Polymerisats peroxidisch oder diaminisch oder bisphenolisch vernetzt sind.

9. Verfahren zur Herstellung eines Presspolsters (1) zur Verwendung in einer hydraulischen Ein- oder Mehretagenheiz- und -Kühlpresse zur Herstellung von Leiterplatten, Hochdrucklaminaten oder ähnlichen Plattenkörpern, das Presspolster (1) umfassend
- zwei auf gegenüberliegenden Seiten des Presspolsters (1) angeordneten Außenschichten (5), die jeweils aus einer Folie aus einem hochtemperaturbeständigen, vorzugsweise thermoplastischen Polymer mit einem sehr niedrigen Reibungskoeffizienten, bestehen,
- eine zwischen den Außenschichten (5) angeordneten Mittelschicht (3) aus einem textilen Flächengebilde (6) aus Fasern und
- zwei jeweils zwischen der Mittelschicht (3) und der jeweiligen Außenschicht (5) angeordnete Verbindungsschichten (4) aus einem fluorierten Kautschuk, vorzugsweise einem Fluorkautschuk,
**dadurch gekennzeichnet, dass** zumindest ein überwiegender Anteil der Fasern, vorzugsweise sämtliche Fasern, des textilen Flächengebildes (6) der Mittelschicht (3) aus einem Material mit einem negativen thermischen Längenausdehnungskoeffizient bestehen, und dass der Fluorelastomer, vorzugsweise das Fluorkautschukmaterial, in einem vorvernetzten Zustand jeweils zwischen eine der beiden Außenschichten (5) und die Mittelschicht (3) eingebracht und dort gleichmäßig und vollflächig verteilt wird und dass in einem solchermaßen gebildeten Mehrschicht-Verbund unter vollflächigem Druck und erhöhter Temperatur der fluorierte Kautschuk, vorzugsweise das Fluorkautschukmaterial, in einen endvernetzten Zustand überführt und dadurch der Mehrschicht-Verbund dauerhaft zu dem Presspolster (1) verklebt wird.

## Claims

1. A press pad a press pad for a hydraulic single-level or multi-level heating and cooling press for producing circuit boards, high pressure laminates or similar plate material, the press pad comprising:
two outer layers arranged on two opposite sides of the press pad and respectively made from a foil made from a high temperature resistant thermoplastic polymer with a very low friction coefficient;
a center layer made from a flat fiber contexture and arranged between the two outer layers; and two connection layers made from a fluor elastomeric material or a fluor rubber and respectively arranged between the center layer and the two outer layers,
wherein at least a major portion of the fibers, or all the fibers of the flat contexture of the center layer are made from a material with a negative thermal expansion coefficient.

2. The press pad according to claim 1, wherein fibers of the flat contexture of the center layer are made from para-aramid and/or meta-aramid and/or or carbon and/or glass, wherein the fibers of the flat contexture are made from one or plural materials including para-aramid and/or meta aramid and/or or carbon and/or glass.

3. The press pad according to claim 1, wherein the center layer includes a woven material, and/or a knitted material, and/or a fleece material, and/or a fleece material, and/or a needle fleece material.

4. The press pad according to claim 1,
wherein the flat contexture of the center layer includes needled on short fibers on both opposite sides of the flat contexture, and
wherein the needled on short fibers are made from the same material as the fibers of the center layer or from a different material.

5. The press pad according to claim 1, wherein the foils of the outer layers are made from polytetrafluorethylene (PTFE), ethylene tetrafluorethylene (ETFE), perfluoralkoxy polymer (PFA) tetrafluoroethylene hexafluoropropylene copolymer (FEP) or polychlorotrifluorotriethylene (PCTFE).

6. The press pad according to claim 5, wherein an entire surface of the foil of the outer layer oriented towards the connection layer is adhesion enhanced by chemical etching or by ionization treatment by a low-pressure plasma.

7. The press pad according to claim 1, wherein the partially crosslinked fluor rubber material is made from
a co-polymer of vinylidene fluoride (VDF) and hexafluoropropylene (HFP), or
a terpolymer of vinylidene fluoride (VDF), hexafluoropropylene (HFP) and tetrafluoroethylene (TFE), or
a polymerized material made from vinylidene fluoride (VDF), hexafluoropropylene (HFP), tetrafluoroethylene (TFE) and perfluoromethylvinyl ether (PMVE), or
a polymerized material made from vinylidene fluoride (VDF), hexafluoropropylene (HFP), tetrafluoroethylene (TFE) and perfluoromethylvinyl ether (PMVE) and ethene.

8. The press pad according to claim, wherein components of the partially crosslinked fluoro rubber polymerized material are cross linked in a peroxidic manner or a diaminic manner or in a bisphenolic manner.

9. A method for producing a press pad for a hydraulic single-level or multi-level heating and cooling press for producing circuit boards, high pressure laminates or similar plate material, the press pad comprising:
two outer layers arranged on two opposite sides of the press pad and respectively made from a foil made from a high temperature resistant thermoplastic polymer with a very low friction coefficient;
a center layer made from a flat fiber contexture and arranged between the two outer layers; and
two connection layers made from a fluor elastomeric material or a fluor rubber and respectively arranged between the center layer and the two outer layers,
wherein at least a major portion of the fibers, advantageously all fibers of the flat contexture of the center layer are made from a material with a negative thermal expansion coefficient,
wherein fluor elastomeric material or the fluor rubber material is introduced in a pre-crosslinked condition between one of the two outer layers and the center layer and distributed evenly over an entire surface area and the fluor elastomeric material of the fluor rubber material is transferred into a completely cross linked condition in the multi-level composite thus formed under pressure over the entire surface area and elevated temperature so that the multi-level composite is permanently glued together with the press pad.

## Revendications

1. Coussinet de presse (1), voué à l'utilisation dans une presse chauffante et refroidissante mono-étagée ou multi-étagée pour la fabrication de cartes de circuit imprimé, de stratifiés haute pression ou de corps en plaques analogues, le coussinet de presse (1) comprenant
- deux couches extérieures (5), placées sur des faces opposées du coussinet de presse (1), dont chacune est constituée d'un film en un polymère de préférence thermoplastique, résistant à de hautes températures, faisant preuve d'un coefficient de friction très bas,
- une couche médiane (3) en une structure textile (6) plane de fibres, placée entre les couches extérieures (5) et
- deux couches d'assemblage (4) en un caoutchouc fluoré, de préférence en un caoutchouc au fluor, placées chacune entre la couche médiane (3) et la couche extérieure (5) concernée,
**caractérisé en ce qu'**au moins une part majoritaire des fibres, de préférence toutes les fibres de la structure textile (6) plane de la couche médiane (3) est/sont constituée(s) d'une matière faisant preuve d'un coefficient d'extension longitudinale négatif.

2. Coussinet de presse (1) selon la revendication 1, **caractérisé en ce que** des fibres de la structure textile (6) plane de la couche médiane (3) sont constituées de para-aramide et/ou de méta-aramide et/ou de carbone (carbone) et/ou de verre, de préférence, **en ce que** les fibres sont exclusivement constituées de l'une des matières précédemment citées ou d'un mélange fibreux de plusieurs des matières précédemment citées.

3. Coussinet de presse (1) selon la revendication 1 ou 2, **caractérisé en ce que** la couche médiane (3) comporte un tissu et/ou un tissu de mailles et/ou un tricot et/ou une matière non-tissée et/ou une matière en feutre, de préférence un feutre aiguilleté.

4. Coussinet de presse (1) selon l'une quelconque des revendications 1 à 3, **caractérisé en ce que** la structure textile (6) plane de la couche médiane (3), est munie superficiellement, de préférence sur les deux faces opposées, de fibres courtes (8) aiguilletées sur celles-ci, constituées de préférence de la même matière que la structure textile (6) plane ou d'une autre matière que les fibres de la structure textile (6) plane.

5. Coussinet de presse (1) selon l'une quelconque des revendications 1 à 4, **caractérisé en ce que** les films des couches extérieures (5) sont constitués de polytétrafluoréthylène (PTFE), d'éthylène-tétrafluoroéthylène (ETFE), d'un polymère perfluoro alcoxy (PFA), d'un copolymère de tétrafluoroéthylène-d'hexafluoropropylène (FEP) ou d'un polychlorotrifluorotriéthylène (PCTFE).

6. Coussinet de presse (1) selon l'une quelconque des revendications 1 à 5, **caractérisé en ce qu'**une surface du film de la couche extérieure (5) qui fait face à la couche d'assemblage (4) est préparée de préférence à pleine surface de manière à renforcer son adhérence, est notamment gravée chimiquement ou soumise à un traitement ionisant, de préférence au moyen d'un plasma basse pression.

7. Coussinet de presse (1) selon l'une quelconque des revendications 1 à 6, **caractérisé en ce que** le polymérisat de caoutchouc fluoré (partiellement réticulé) est constitué
- d'un copolymère de fluorure de vinylidène (VDF) et d'hexafluoropropylène (HFP) ou
- d'un terpolymère de fluorure de vinylidène (VDF), d'hexafluoropropylène (HFP) et de tétrafluoroéthylène (TFE) ou
- d'un polymérisat de fluorure de vinylidène (VDF), d'hexafluoropropylène (HFP), de tétrafluoroéthylène (TFE) et de perfluorométhylvinyléther (PMVE) ou
- d'un polymérisat de fluorure de vinylidène (VDF), d'hexafluoropropylène (HFP), de tétrafluoroéthylène (TFE), de perfluorométhylvinyléther (PMVE) et d'éthylène.

8. Coussinet de presse (1) selon l'une quelconque des revendications 1 à 7, **caractérisé en ce que** des composants du polymérisat de caoutchouc fluoré (partiellement réticulé) sont réticulés au peroxyde ou aux diamines ou au bisphénol.

9. Procédé, destiné à fabriquer un coussinet de presses (1) voué à l'utilisation dans une presse chauffante et refroidissante mono-étagée ou multi-étagée pour la fabrication de cartes de circuit imprimé, de stratifiés haute pression ou de corps en plaques analogues, le coussinet de presse (1) comprenant
- deux couches extérieures (5), placées sur des faces opposée du coussinet de presse (1), dont chacune est constituée d'un film en un polymère de préférence thermoplastique, résistant à de hautes températures, faisant preuve d'un coefficient de friction très bas,
- une couche médiane (3) en une structure textile (6) plane de fibres, placée entre les couches extérieures (5) et
- deux couches d'assemblage (4) en un caoutchouc fluoré, de préférence en un caoutchouc au fluor, placées chacune entre la couche médiane (3) et la couche extérieure (5) concernée ,
**caractérisé en ce qu'**au moins une part majoritaire des fibres, de préférence toutes les fibres de la structure textile (6) plane de la couche médiane (3) sont constituée(s) d'une matière faisant preuve d'un coefficient d'extension longitudinale négatif et **en ce que** l'on introduit dans un état préalablement réticulé chaque fois entre l'une des deux couches extérieures (5) et la couche médiane (3) l'élastomère fluoré, de préférence la matière en caoutchouc fluoré et on l'y distribue régulièrement et à pleine surface et **en ce que** dans un composite multicouches conçu de la sorte, sous une pression à pleine surface et une température élevée, l'on fait passer le caoutchouc fluoré, de préférence la matière en caoutchouc fluoré dans un état de réticulation finale et de ce fait, l'on colle durablement le composite multicouches pour obtenir le coussinet de presse (1).
